Europäisches Patentamt

European Patent Office

Office européen des brevets

(11) Veröffentlichungsnummer: **0 157 226**
A1

## (12) EUROPÄISCHE PATENTANMELDUNG

(21) Anmeldenummer: 85102699.7

(22) Anmeldetag: 09.03.85

(51) Int. Cl.⁴: **H 01 L 21/28**, H 01 L 29/64

(30) Priorität: 15.03.84 GB 8406722

(43) Veröffentlichungstag der Anmeldung: 09.10.85
Patentblatt 85/41

(84) Benannte Vertragsstaaten: DE FR IT NL

(71) Anmelder: Deutsche ITT Industries GmbH,
Hans-Bunte-Strasse 19 Postfach 840, D-7800 Freiburg
(DE)

(84) Benannte Vertragsstaaten: DE

(71) Anmelder: ITT INDUSTRIES INC., 320 Park Avenue, New
York, NY 10022 (US)

(84) Benannte Vertragsstaaten: FR IT NL

(72) Erfinder: Young, John Michael, 46 Paddock Mead,
Harlow Essex (GB)

(74) Vertreter: Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)

(54) Verfahren zur Herstellung eines Feldeffekttransistors.

(57) Eine selbstausrichtende Gatestruktur eines Verbindungshalbleiter-Feldeffekttransistors (MESFETs) wird aus einer Siliziumschicht (14) mit darüber angeordneter Metallschicht (15) aus z.B. Nickel gebildet. Das Metall bildet eine Ätzmaske für das Silizium und anschließend eine Implantationsmaske für die Herstellung der Drain- und Sourcezonen (18, 19). Ätzen der Siliziumschicht (14) führt zu einem Unterätzen, wodurch das Gate (17) von der Drain- und Sourcezone (18, 19) getrennt wird. Erhitzen der Struktur zum Tempern der Implantation führt zum Eindiffundieren des Metalls in das Silizium und zur Ausbildung einer Metallsilizid-Gateelektrode (20).

0157226

J.M. Young 10

Fl 1239 EP
Dr.Rl/Be
5. März 1985

## Verfahren zur Herstellung eines Feldeffekttransistors

Die Priorität der Anmeldung Nr. 8406722 vom 15. März 1984
in Großbritannien wird beansprucht.

Die Erfindung betrifft Verfahren zur Herstellung von Feldeffekttransistoren und insbesondere solche Transistoren,
die in einem III-V Halbleiterkörper wie z.B. Galliumarsenid hergestellt werden.

Mit dem zunehmenden Bedürfnis, die Grenzfrequenz eines
Bauelements zu erhöhen, wurde bei der Herstellung von sehr
schnellen integrierten Schaltungen Silizium durch Verbindungshalbleiter ersetzt. Das dabei am häufigsten verwendete neue Material ist Galliumarsenid. Herkömmliche Feldeffekttransistoren (MESFETs) werden in diesem Material
so hergestellt, daß selektiv eine n-leitende Kanalzone
in dem semi-intrinsischen Galliumarsenid-Substrat und hochdotierte $n^+$-leitende Source- und Drainzonen implantiert
und ohmsche Kontakte an den letzteren ausgebildet werden.
Das Gatemetall, üblicherweise Chrom/Gold, wird dann zwischen den Source- und Drainzonen angeordnet. Weitere Goldschichten können z.B. bei der Herstellung von integrierten
Schaltungen zur Ausbildung von Zwischenverbindungen abgeschieden werden.

Von den in diesem Verfahren angewandten Photolithographieschritten ist der besonders kritisch, durch den das Gate
des Transistors festgelegt wird. Für einen optimalen Betrieb müssen die Gatemetallstreifen nicht nur sehr schmal
sein, tunlichst ein 1 $\mu$m oder noch darunter, sondern sie müssen auch vom Sourcebereich durch einen ähnlich geringen Abstand getrennt sein. Diese räumlichen Anforderungen sind erforderlich, um die parasitären Serienwiderstände zwischen der Source und dem Kanal des Transistors herabzusetzen. Es ist einzusehen, daß die Anwendung eines Photolithographieverfahrens mit derartig kritischen Abstandstoleranzen zu einer geringen Ausbeute und/oder überhöhten und unterschiedlichen Serienwiderständen führt.

Beim Versuch zur Lösung dieses Problems wurde eine Reihe von Verfahren entwickelt, bei denen Source- und Drainzonen gegenüber dem Gate selbstausrichtende sind. Bei einem typischen Verfahren dieser Art wird ein Gatematerial verwendet, das gegenüber den zum Tempern des Source-Drain-Implantats erforderlichen Temperaturen stabil ist. Das Gate wird vor dem Implantationsschritt und dem nachfolgenden Tempern festgelegt. Beim fertigen Bauelement ist dann zwischen der Sourcezone mit hoher Leitfähigkeit und dem gesteuerten Kanal kein Abstand. In der Praxis führt diese Technik des "Nullabstandes" zu weiteren Schwierigkeiten, da die zwischen dem Gate und der Source entstehende Diode keine Sperreigenschaften besitzt.

Hier will die Erfindung Abhilfe schaffen. Die Erfindung, wie sie in den Ansprüchen gekennzeichnet ist, löst die Aufgabe, ein Verfahren zur Herstellung eines Feldeffekttransistors anzugeben, dem die genannten Nachteile nicht anhaften. Die durch die Erfindung erreichten Vorteile sind in der Lösung der Aufgabe sowie in der Möglichkeit zu sehen, mit dem erfindungsgemäßen Verfahren Transistoren wie auch integrierte Schaltungen unter Zugrundelegung von unterschiedlichen Verbindungshalbleitern herzustellen.

0157226

J.M. Young 10                               Fl 1239 EP

Die Erfindung betrifft ein Verfahren zur Herstellung eines Feldeffekttransistors in einem Verbindungshalbleiter, wobei auf einer der Hauptflächen eines Halbleitersubstrats eine Siliziumschicht abgeschieden wird und selektiv Metall zur Festlegung des Gatebereiches des Transistors auf der besagten Schicht abgelagert wird. Unter Verwendung des Metalls als Maske zur Festlegung der Abstände von Gate/ Drain und Gate/Source werden die Drain- und Sourcezonen implantiert. Das freiliegende Silizium wird entfernt und das Metall unterätzt. Das Bauelement wird schließlich erwärmt, wodurch die implantierten Zonen getempert und aktiviert werden und das Metall teilweise oder vollständig in das verbliebene Silizium unter Ausbildung eines Metallsilizid-Gate eindiffundiert.

In einer bevorzugten Ausbildungform wird die relative Stärke der Silizium- und der Metallschicht derart gewählt, daß nach Verbrauch des Metalls ein stöchiometrisches Verhältnis erreicht wird. Als Metall wird vorzugsweise Nickel verwendet.

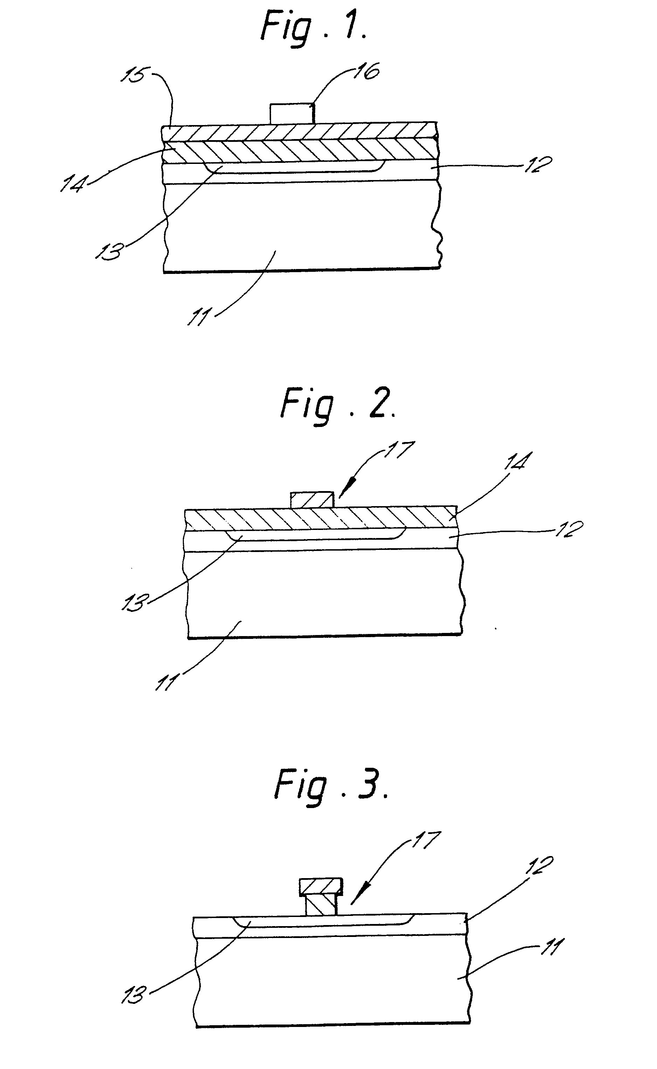

Die Erfindung wird nachstehend anhand eines in den Figuren der Zeichnung dargestellen Ausführungsbeispiels näher erläutert. Die Fig. 1 bis 5 stellen dabei Schnitte durch die aufeinanderfolgenden Herstellungsstufen eines Feldeffekttransistors, z.B. in einer integrierten Schaltung, dar.

EIn aus z.B. Galliumarsenid bestehendes Halbleitersubstrat 11 (Fig. 1) wird durch z.B. Epitaxie mit einer Oberflächenschicht 12 versehen. Sie ist aus halbisolierendem Material

J. M. Young 10                              Fl 1239

mit geringer Leitfähigkeit, das sehr wenig freie Elektronen besitzt ( üblicherweise $10^9$ . $cm^{-3}$). In diese Schicht 12 wird selektiv durch eine erste nichtgezeigte Maske eine mäßig dotierte n-leitende Kanalzone 13 implantiert. Das Material des Kanals besitzt eine Elektronenkonzentration von $10^{17}$ . $10^{-3}$ in seinem Leitungsband. Wahlweise kann man auch eine flächenhafte Kanalimplantation vornehmen und die einzelnen Bauelementbereiche durch Protonenimplantation isolieren. Eine andere Möglichkeit besteht in der Verwendung eines halbisolierenden Substrates, so daß auf die Oberflächenschicht 12 verzichtet werden kann.

Die Halbleiteroberfläche wird daraufhin unter Zuhilfenahme einer der bekannten Abscheidetechniken mit einer Siliziumschicht 14 versehen.

Eine Metallschicht 15 aus z.B. Nickel, das in der Lage ist, ein Silizid zu bilden, wird daraufhin abgeschieden. Es folgt eine Photolackmaske 16, unter deren Zuhilfenahme (Fig. 2) der Aufbau zur Entfernung der freiliegenden Metallschicht 15 geätzt wird. Dabei wird die Gatezone 17 des Transistors in Bezug auf die Kanalzone 13 festgelegt.

Der Aufbau wird daraufhin einem Ätzmittel, z.B. einem Plasma aus Fluorkohlenwasserstoff/Sauerstoff ausgesetzt, um die freien Teile der Siliziumschicht 14 zu entfernen und die Kanten der Gatezone 17 zu unterätzen. Dies bewirkt eine gesteuerte Trennung zwischen Source- und Drainzonen und dem Gate.

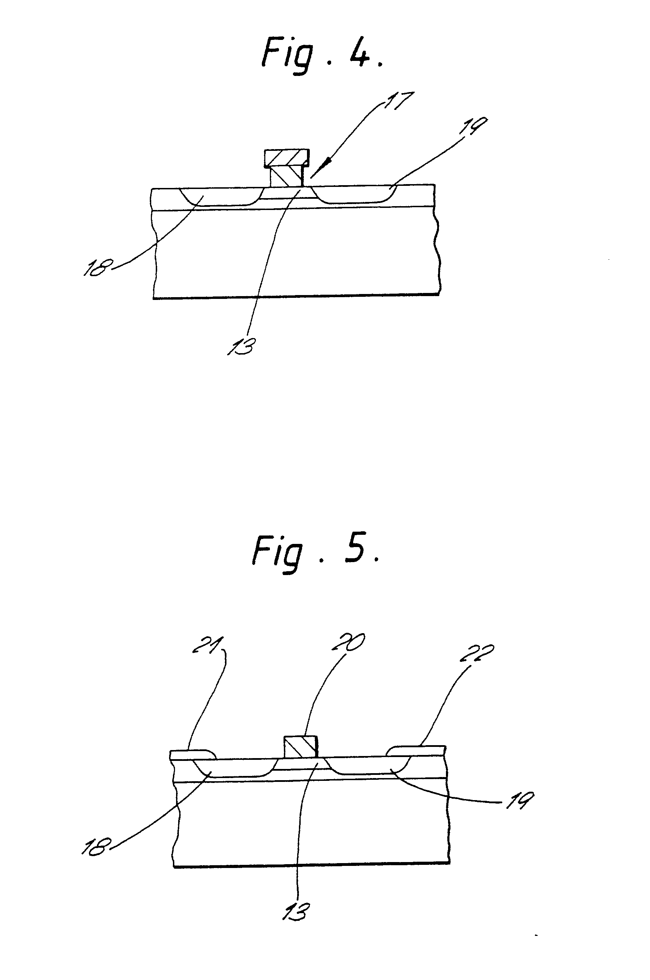

Eine zweite, nicht gezeigte Maske wird aufgebracht und die Drainzone 18 und die Sourcezone 19 (Fig. 4) durch Ionenimplantation erzeugt. Das unterätzte Metallgate wirkt

0157226

J. M. Young 10 Fl 1239 EP

als Maske zur Festlegung der Kanten der Source- und Drainzone und bewirkt so einen bestimmten Abstand vom Gate, der durch den Grad des Unterätzens bestimmt wird. Diese Technik ergibt eine automatische Ausrichtung von Drain- und Sourcezone gegenüber dem Gate. Üblicherweise sind Drain- und Sourcezone bis zu einer Verunreinigungkonzen-tration von $10^{20}$ bis $10^{21}$ cm$^{-3}$ dotiert.

Der Aufbau wird danach erhitzt, um das Implantat zu tempern und gleichzeitig das Metall in das Silizium einzudiffundieren, so daß sich eine Metallsilizid-Gateelektrode 20 (Fig. 5) bildet. Eine weitere nichtgezeigte Maske wird dann aufgebracht, mit deren Hilfe ein Kontaktmetall oder eine Legierung zur Herstellung der Drain- und Sourceelektroden 21, 22 und des nichtgezeigten Gatekontaktes abgeschieden werden. Der Aufbau kann dann von dem Wafer getrennt und verkapselt werden.

In einer bevorzugten Ausbildungsform ist die relative Stärke der Silizium- und Metallschicht so gewählt, daß nach Vollendung des Diffusionsschrittes ein Silizid mit der entsprechenden stöchiometrischen Zusammensetzung sich gebildet hat und das gesamte freie Metall verbraucht ist.

In einer anderen Anwendungsform wird mit einem Überschuß an Metall gearbeitet, so daß nach der Silizidbildung eine Metallschicht auf dem Gate zurückbleibt. Andererseits kann man auch mit einem Überschuß an Silizium arbeiten, um die Höhe der Sperrschicht zu verbessern.

Es ist noch anzumerken, daß das Verfahren, obgleich in Verbindung mit der Herstellung eines Einzeltransistors beschrieben, auch für die gleichzeitige Herstellung einer Vielzahl von Transistoren, z.B. bei der Herstellung von integrierten Schaltungen angewendet werden kann. Ebenso

- 6 -    0157226

J.M. Young 10                          Fl 1239 EP

läßt sich das Verfahren auf die Herstellung von Bauelementen in anderen Verbindungshalbleitern als Galliumarsenid übertragen.

J.M. Young 10

Fl 1239 EP
Dr.Rl/Be
5. März 1985

Patentansprüche

1. Verfahren zur Herstellung eines Feldeffekttransistors in einem Verbindungshalbleiter, gekennzeichnet durch folgende Verfahrensschritte:
   - Abscheiden einer Siliziumschicht (14) auf einer der eine Kanalzone (13) enthaltenden Hauptfläche eines Halbleitersubstrats (11),
   - selektives Abscheiden einer Metallschicht (15) zur Festlegung der Gatezone (17),
   - Abätzen der freiliegenden Siliciumschicht (14) und Unterätzen der Gatezone (17),
   - Ionenimplantation von Source- und Drainzone (18, 19),
   - Tempern des Implantats und gleichzeitiges Eindiffundieren des Metalls der Gatezone (17) in das Silizium unter Ausbildung einer Metallsilizid-Gateelektrode (20).

2. Verfahren nach Anspruch 1, dadurch gekennzeichnet, daß die Kanalzone (13) in einer auf der Hauptfläche abgeschiedenen Oberflächenschicht (12) angeordnet wird.

3. Verfahren nach einem der Ansprüche 1 oder 2, dadurch gekennzeichnet, daß eine Metallschicht (15) aus Nickel verwendet wird.

4. Verfahren nach einem der Ansprüche 1 bis 3, dadurch gekennzeichnet, daß als Verbindungshalbleiter Galliumarsenid verwendet wird.

5. Verfahren nach einem der Ansprüche 1 bis 4, dadurch gekennzeichnet, daß das freiliegende Silizium mittels eines Fluorkohlenwasserstoffplasmas entfernt wird.

J.M Young 10                                    Fl 1239 EP

6. Verfahren nach einem der Ansprüche 1 bis 5, dadurch
   gekennzeichnet, daß die Stärke der Silizium- und Metallschichten so gewählt ist, daß bei Verbrauch des gesamten Metalls eine stöchiometrische Zusammensetzung
   resultiert.

Fig . 1.

Fig . 2.

Fig . 3.

0157226

# Fig . 4.

17

19

18

13

# Fig . 5.

21    20    22

18

19

13

Europäisches
Patentamt

EUROPÄISCHER RECHERCHENBERICHT

0157226
Nummer der Anmeldung

EP 85 10 2699

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 057 558 (FUJITSU) * Seite 12, Zeilen 22-34; Seite 13, Zeile 30 - Seite 14, Zeile 8 * | 1,4 | H 01 L 21/28 H 01 L 29/64 |
| | --- | | |
| A | PATENT ABSTRACTS OF JAPAN, Band 7, Nr. 243, 28. Oktober 1983, Seite (E-207)(1388); & JP-A-58-132 977 (TOKYO SHIBAURA) 08-08-1983 | 1,4 | |
| | --- | | |
| A | IBM TECHNICAL DISCLOSURE BULLETIN, Band 19, Nr. 9, Februar 1977, New York, USA; P.J. TSANG "Forming thick metal silicide for contact barrier", Seiten 3383-3385 * Seite 3384, Absatz 4 * | 6 | |
| | ----- | | |

RECHERCHIERTE SACHGEBIETE (Int. Cl.4)

H 01 L 21/28
H 01 L 29/40
H 01 L 29/80

Der vorliegende Recherchenbericht wurde für alle Patentansprüche erstellt.

| Recherchenort BERLIN | Abschlußdatum der Recherche 04-06-1985 | Prüfer GIBBS C.S. |
|---|---|---|